# EUROPEAN PATENT APPLICATION

(11) **EP 4 730 146 A1**
(43) Date of publication of application: **22.04.2026**
(21) Application number: 24823205.0
(22) Date of filing: 24.05.2024
(51) Int. Cl.: G06F 15/78, H05K 3/00

(54) **GENERAL-PURPOSE CONTROL BOARD**

(30) Priority: 16.06.2023 JP 2023099242
(71) Applicant: GLORY LTD., Himeji-shi Hyogo 670-8567 (JP)
(72) Inventor: TACHIBANA, Yusaku, Himeji-shi, Hyogo 670-8567 (JP)
(74) Representative: SSM Sandmair
(86) International application number: PCT/JP2024/019225
(87) International publication number: WO 2024/257584

(57) **Abstract**

A general-purpose control board includes a core module 10 and an expansion module 20 such that a product can be manufactured efficiently even if a component mounted on a product-specific printed circuit board is replaced with an alternative component. A CPU 11 of the core module 10 includes a program that realizes cumulative specifications required to control a plurality of products anticipated in advance. A plurality of functional logics that control sensor circuits 32 and motor circuits 33 from a plurality of manufacturers, which are mounted for each apparatus, are implemented in FPGAs mounted on the core module 10 and the expansion module 20. The CPU 11 automatically determines which manufacturer's sensor circuit 32 and/or motor circuit 33 have been mounted, and notifies FPGAs 12, 21 of the determination result, to select and use one of the plurality of functional logics implemented in the FPGAs 12, 21.

## Description

### TECHNICAL FIELD

The present disclosure relates to a general-purpose control board capable of supporting the replacement of a component mounted on a product-specific printed circuit board.

### BACKGROUND ART

Conventionally, when the manufacturing of a component has been discontinued, there is a known technique that enables the use of a substitute component without selecting a compatible component or newly designing and producing an alternative component. For example, Patent Literature 1 discloses a conversion adapter on which a programmable device, such as an FPGA (Field Programmable Gate Array) that enables users to freely configure circuits, is mounted as a compatible component. Functional logics that correspond respectively to multiple types of electronic components are written in the programmable device in advance. When an electronic component used on an existing board becomes unavailable due to manufacturing discontinuation or the like, the programmable device emulates the function of the discontinued component, whereby an alternative to the discontinued component is realized.

### CITATION LIST

### [PATENT LITERATURE]

[PTL 1] Japanese Patent No. 4717554

### SUMMARY OF THE INVENTION

### PROBLEMS TO BE SOLVED BY THE INVENTION

However, the technique in the above Patent Literature 1 is for enabling configuration of an alternative to the electronic component, such as an IC or a memory mounted on a printed circuit board, when the electronic component has been discontinued. A product incorporates not only electronic components such as an IC and a memory but also a processor that controls the entire product and a programmable device that controls the IC and other components. The conventional technique cannot be applied when such a processor or a programmable device becomes unavailable.

The present disclosure is made in view of the problems in the above conventional art, and one object of the present disclosure is to provide a general-purpose control board capable of efficiently manufacturing a product even if a component mounted on a product-specific printed circuit board is replaced with an alternative component.

### SOLUTION TO THE PROBLEMS

A general-purpose control board according to one aspect of the present disclosure can be mounted on both a first specific board mounted in a first apparatus and a second specific board mounted in a second apparatus. The general-purpose control board includes a processor configured to execute a first application that controls a user interface of an apparatus and realizes a function of the apparatus, to control the apparatus, and a programmable device configured to incorporate a second application that operates a specific board in the apparatus, based on the first application executed by the processor.

In the above configuration, the general-purpose control board may include a first board including the processor and the first programmable device, and a second board including the second programmable device connected to the first programmable device.

In the above configuration, the first board may be connected to the second board using a serial I/O interface.

In the above configuration, the first board and the second board may communicate with each other by encrypting data.

In the above configuration, the first application may be able to be modified only from a first control device, and the second application may be able to be modified from the first control device and a second control device.

In the above configuration, the apparatus may be a valuable media processing apparatus configured to process a valuable medium.

In the above configuration, the valuable media processing apparatus may include a plurality of sensors and/or a plurality of motors that are used for processing a valuable medium, and the plurality of sensors and/or the plurality of motors may be electrically connected to the programmable device.

In the above configuration, the plurality of sensors and/or the plurality of motors may be electrically connected to the processor via the programmable device.

In the above configuration, the valuable media processing apparatus may further include a safe, and the specific board on which the general-purpose control board is mounted may be stored in the safe.

### ADVANTAGEOUS EFFECTS OF THE INVENTION

According to the present disclosure, it is possible to provide a general-purpose control board capable of efficiently manufacturing a product even if a component mounted on a product-specific printed circuit board is replaced with an alternative component.

### BRIEF DESCRIPTION OF THE DRAWINGS

[FIG. 1] FIG. 1 illustrates an outline of a general-purpose control board according to an embodiment.
[FIG. 2] FIG. 2 illustrates an example of a valuable media processing apparatus in which a base board shown in FIG. 1 is mounted.
[FIG. 3] FIG. 3 shows an outline of a mounting configuration of the general-purpose control board and the base board in the valuable media processing apparatus.
[FIG. 4] FIG. 4 shows another configuration example of a core module.
[FIG. 5] FIG. 5A shows a configuration example of programs implemented in the core module and FIG. 5B shows a configuration example of functions implemented in FPGA.
[FIG. 6] FIG. 6 shows a configuration example of an expansion module.
[FIG. 7] FIG. 7 shows a mounting example of the base board using only the core module.
[FIG. 8] FIG. 8 shows a mounting example of the core module and the expansion module.
[FIG. 9] FIG. 9 shows another mounting example of the core module and expansion modules.
[FIG. 10] FIG. 10 illustrates an outline of a security-assured mounting example in the valuable media processing apparatus.

### DESCRIPTION OF EMBODIMENT

Hereinafter, a general-purpose control board according to the present disclosure will be described in detail with reference to the drawings.

### <Outline of general-purpose control board>

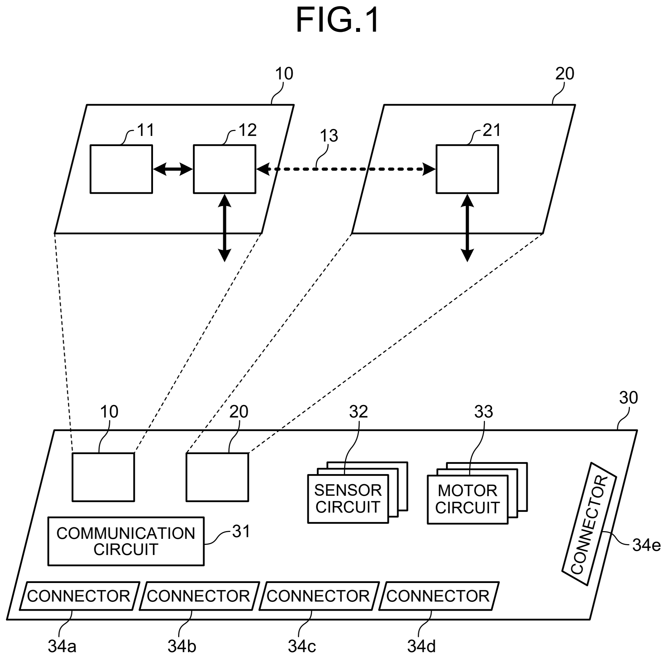

An outline of the general-purpose control board according to the present embodiment will be described. FIG. 1 illustrates the outline of the general-purpose control board according to the present embodiment. A core module 10 shown in FIG. 1 correspond to the general-purpose control board described in the present embodiment. The general-purpose control board may further include an expansion module 20.

The core module 10 includes a CPU 11 that controls the entirety of an apparatus in which the general-purpose control board is mounted, and an FPGA 12 that controls a plurality of sensor circuits 32 and a plurality of motor circuits 33.

The expansion module 20 includes an FPGA 21 for expanding functionality by increasing the number of mounted sensor circuits 32 and the number of mounted motor circuits 33. The core module 10 and the expansion module 20 are mounted on a base board 30 developed for each product. The core module 10 is connected to the expansion module 20 via a connection cable 13 or wiring formed on the base board 30. The core module 10 is connected to the expansion module 20 using a serial I/O interface. For example, RS-232C which is an unbalanced transmission method, RS-422 which is a differential transmission method, or LVDS (Low Voltage Differential Signaling) may be used as the serial I/O interface. Control signals from the CPU 11, sensor data from the FPGA 21, etc. are transmitted between the core module 10 and the expansion module 20 using the serial I/O interface. In the core module 10, the CPU 11 is connected to the FPGA 12 using an external bus interface of the CPU 11. The CPU 11 is connected to the FPGA 12 using a parallel I/O interface. The FPGA 12 and the FPGA 21, and the external sensor circuits 32 and the external motor circuits 33 are also connected using a parallel I/O interface.

The base board 30 developed for each product includes the core module 10, the expansion module 20, a communication circuit 31, the plurality of sensor circuits 32, the plurality of motor circuits 33, and a plurality of connectors 34a, 34b, 34c, 34d, 34e (hereinafter, sometimes collectively referred to as "connector 34"). The connector 34 is used for connections with devices such as a sensor and a motor.

The communication circuit 31 is a circuit for communicating with a management device or the like that manages products. The sensor circuits 32 are connected to the connector 34 via the wiring formed on the base board 30. The sensor circuits 32 are circuits for receiving signals from sensors connected to the connector 34. The motor circuits 33 are connected to the connector 34 via the wiring formed on the base board 30. The motor circuits 33 are circuits for driving motors connected to the connector 34.

The core module 10 and the expansion module 20 are mounted on the base board 30 using connectors. For example, the core module 10 and the expansion module 20 may be provided with surface mount terminals (e.g., BGA (Ball Grid Array)) on the rear sides thereof, to be surface-mounted on the base board 30.

A control program of the CPU 11 mounted on the core module 10 includes a program that controls a user interface or the like commonly used across a plurality of products, and a program that realizes cumulative specifications required to control multiple types of products anticipated in advance. The control program will be described in detail below.

A plurality of functional logics for controlling the sensor circuits 32 and the motor circuits 33 from multiple manufacturers, which are mounted on the base board 30 developed for each apparatus, are implemented in the FPGA 12 mounted on the core module 10 and the FPGA 21 mounted on the expansion module 20. That is, when an apparatus is developed, the base board 30 on which the CPU 11, at least one FPGA 12, and at least one FPGA 21 are removably mounted is prepared for the apparatus. The functional logics corresponding respectively to multiple types of external devices such as a sensor and a motor which may be used in the apparatus are implemented in the FPGAs 12, 21 in advance. The CPU 11 automatically determines the manufacturer of each of the mounted sensor circuits 32 and/or the mounted motor circuits 33. The CPU 11 notifies the FPGA 12 and the FPGA 21 of the determination result, to select one corresponding to each of the sensor circuits 32 and the motor circuits 33 from the plurality of functional logics implemented in the FPGA 12 and the FPGA 21. A functional logic for automatic determination may be implemented in the FPGA 12 and the FPGA 21, and may be used to determine the manufacturers of the mounted sensor circuits 32 and/or the mounted motor circuits 33.

As described above, the general-purpose control board according to the present embodiment includes the core module 10 and the expansion module 20. The CPU 11 of the core module 10 can execute the program that controls the user interface or the like commonly used across the plurality of products, and the program that realizes the cumulative specifications required to control the plurality of products anticipated in advance. The plurality of functional logics that control multiple types of the sensor circuits 32 and the motor circuits 33 mounted in the base board 30 developed for each apparatus, are implemented in the FPGA 12 mounted on the core module 10 and the FPGA 21 mounted on the expansion module 20. The CPU 11 automatically determines the type of each of the mounted sensor circuits 32 and/or the mounted motor circuits 33, and notifies the FPGA 12 and the FPGA 21 of the determination result, to select corresponding one from the plurality of functional logics implemented in the FPGA 12 and the FPGA 21. Thus, in a case where the general-purpose control board is used, even if a component mounted on the printed circuit board specific to a product is replaced with an alternative component, the product can be manufactured efficiently. Specifically, for example, even if the type of the sensor circuit 32 mounted on the base board 30 has been changed due to the replacement of a sensor with an alternative component, the core module 10 and the expansion module 20 which have been previously used can be mounted on the updated base board 30, and it is possible to realize control of the alternative sensor.

The general-purpose control board can be commonly used across a plurality of apparatuses. Thus, maintaining a large stock of the general-purpose control boards allows the impact on product manufacturing to be suppressed even if it has become difficult to obtain the CPU 11, the FPGA 12, and the FPGA 21, which are mounted on the general-purpose control board.

### <Outline of valuable media processing apparatus>

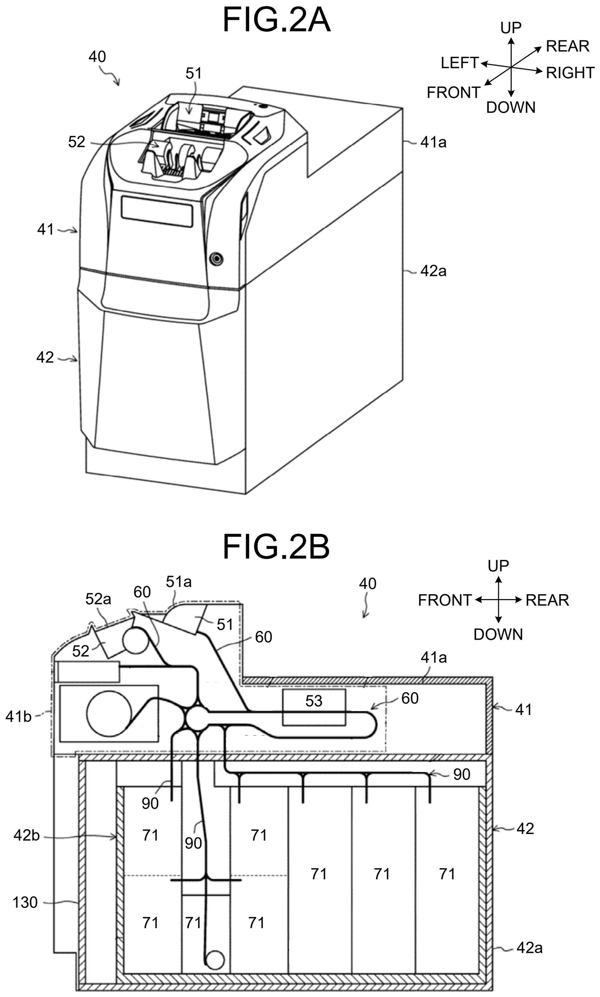

As an example of an apparatus in which the base board 30 is mounted, an outline of a valuable media processing apparatus 40 will be described. FIG. 2 shows a perspective view of the external appearance and a schematic diagram of the configuration of the valuable media processing apparatus 40 in which the base board 30 shown in FIG. 1 is mounted.

Directions (front-rear, left-right, up-down) used in the following description correspond to directions when the valuable media processing apparatus 40 installed on the horizontal plane is viewed from the front surface. A front-side portion of the valuable media processing apparatus 40 is a part where a depositing unit 51 and a dispensing unit 52 are formed. A rear-side portion of the valuable media processing apparatus 40 is located opposite to the part where the depositing unit 51 and the dispensing unit 52 are formed.

The valuable media processing apparatus 40 includes a handling unit 41 and a safe unit 42. The handling unit 41 is disposed above the safe unit 42.

The handling unit 41 includes a handling housing 41a and a movable handling unit 41b. The handling housing 41a is formed as a box that has a rectangular parallelepiped shape, extends in the front-rear direction, and opens toward the front. The handling housing 41a stores therein the movable handling unit 41b. The movable handling unit 41b can be pulled out forward from the handling housing 41a. The movable handling unit 41b includes the depositing unit 51, the dispensing unit 52, a recognition unit 53, and a handling-side transport unit 60.

The depositing unit 51 is an insertion unit in which a banknote is inserted. The depositing unit 51 is disposed in the font portion of the movable handling unit 41b. The depositing unit 51 includes an inlet 51a that opens upward. An operator manually inserts a banknote in the depositing unit 51 via the inlet 51a. The depositing unit 51 can hold a plurality of banknotes stacked together. The depositing unit 51 is provided with a feeding mechanism that feeds the banknotes inserted in the depositing unit 51, one by one, to the handling-side transport unit 60.

The dispensing unit 52 is a discharge unit from which a banknote is dispensed. The dispensing unit 52 is disposed in a front portion of the movable handling unit 41b and is positioned in front of the depositing unit 51. The dispensing unit 52 can hold a plurality of banknotes stacked together. The operator can manually take out the banknotes stacked in the dispensing unit 52 via an outlet 52a. The dispensing unit 52 may be provided with a shutter that opens and closes the outlet 52a.

The recognition unit 53 recognizes banknotes. The recognition unit 53 is disposed on the handling-side transport unit 60, and performs a recognition process on banknotes transported by the handling-side transport unit 60. In the recognition process, the recognition unit 53 recognizes the denomination of each banknote. The recognition unit 53 may recognize fitness, old/new, authentication, a transport state, a serial number assigned to the banknote, etc. For example, the base board 30 is used by the recognition unit 53.

The handling-side transport unit 60 transports banknotes inside the handling unit 41. The handling-side transport unit 60 continuously transports a plurality of banknotes while maintaining spacing between the banknotes in the transport direction. The handling-side transport unit 60 transports the banknotes such that the edge of a long side of each banknote faces the front in the transport direction. Alternatively, the handling-side transport unit 60 may transport the banknotes such that the edge of a short side of each banknote faces the front in the transport direction.

The handling-side transport unit 60 includes a transport path. For example, the transport path includes: a transport mechanism for transporting banknotes, including a transport roller, a transport belt, and the like; a guide member that guides the banknotes being transported; and a diverter mechanism for switching the transport direction of the banknotes, such as a diverter claw. The handling-side transport unit 60 includes a drive mechanism including a motor, a gear, and the like. The drive mechanism drives the transport mechanism and the diverter mechanism of the transport path. The transport path of the handling-side transport unit 60 is connected to the depositing unit 51, the dispensing unit 52, and a safe-side transport unit 90 described below.

The safe unit 42 includes a safe housing 42a and a movable safe unit 42b. The safe housing 42a is formed as a box that has a rectangular parallelepiped shape and extends in the front-rear direction. A door 130 that can be opened and closed is provided at a front-end portion of the safe housing 42a. The door 130 can be locked. For example, the door 130 includes an electronic lock. The safe housing 42a stores therein the movable safe unit 42b. The protection level of the safe housing 42a is higher than that of the handling housing 41a. Specifically, the safe housing 42a is formed of a metal plate having a thickness equal to or greater than a predetermined thickness. The movable safe unit 42b can be pulled out forward. When the door 130 of the safe housing 42a is opened, the operator can pull out the movable safe unit 42b forward from the safe housing 42a.

The movable safe unit 42b includes a plurality of storage devices 71 and the safe-side transport unit 90. Each of the plurality of storage devices 71 stores therein banknotes. Each of the plurality of storage devices 71 feeds the stored banknotes.

The safe-side transport unit 90 transports banknotes inside the safe unit 42. The safe-side transport unit 90 continuously transports a plurality of banknotes while maintaining spacing between the banknotes in the transport direction. The safe-side transport unit 90 transports the banknotes such that the edge of a long side of each banknote faces the front in the transport direction. Alternatively, the safe-side transport unit 90 may transport the banknotes such that the edge of a short side of each banknote faces the front in the transport direction.

The safe-side transport unit 90 includes a transport path. For example, the transport path includes: a transport mechanism for transporting banknotes, including a transport roller, a transport belt, and the like; a guide member that guides banknotes being transported; and a diverter mechanism for switching the transport direction of banknotes, such as a diverter claw. The safe-side transport unit 90 includes a drive mechanism including a motor, a gear, and the like. The drive mechanism drives the transport mechanism and the diverter mechanism of the transport path.

The transport path of the safe-side transport unit 90 is connected to the handling-side transport unit 60 through a through passage formed in an upper-wall portion of the safe housing 42a. The transport path of the safe-side transport unit 90 is connected to the plurality of storage devices 71.

The valuable media processing apparatus 40 having the above-described configuration can perform various banknote handling processes including depositing and dispensing of banknotes. Since the contents of each banknote handling process and the operation of each component during the banknote handling process have been conventionally known, description thereof is omitted.

Next, an outline of a mounting configuration of the general-purpose control board and the base board 30 in the valuable media processing apparatus 40 will be described. Hereinafter, the same parts as those in the outline of the general-purpose control board and the base board 30 shown in FIG. 1 are denoted by the same reference characters and the detailed description thereof is omitted.

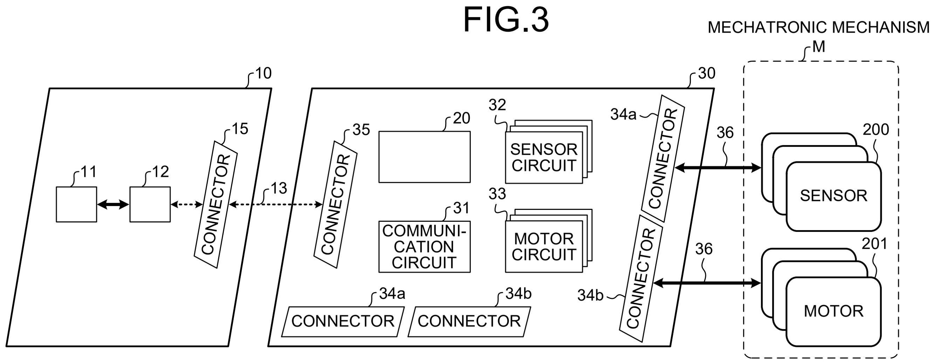

FIG. 3 shows the outline of the mounting configuration of the general-purpose control board and the base board 30 in the valuable media processing apparatus 40. FIG. 1 shows an example in which the core module 10 and the expansion module 20 are mounted on the base board 30. On the other hand, the core module 10 shown in FIG. 3 is spaced from the base board 30, that is, the core module 10 may be disposed independently of the base board 30.

As shown in FIG. 3, the valuable media processing apparatus 40 incorporates the core module 10 of the general-purpose control board, the base board 30 developed for each apparatus, and a mechatronic mechanism M. The core module 10 includes the CPU 11, the FPGA 12, and a connector 15 for transmitting serial I/O signals, which are disposed on a printed circuit board.

In the core module 10, the CPU 11 is connected to the FPGA 12 via wiring formed on the printed circuit board using an external bus interface of the CPU 11. The external bus interface of the CPU 11 transmits parallel I/O signals. The FPGA 12 is connected to the connector 15 via the wiring formed on the printed circuit board. The FPGA 12 is connected to the connector 15 using a serial I/O interface. The core module 10 may be provided with connectors for connections with the sensor circuits 32 and the motor circuits 33.

The base board 30 includes the expansion module 20, the communication circuit 31, the plurality of sensor circuits 32, the plurality of motor circuits 33, and a plurality of connectors 34a, 34b, 35. The expansion module 20 is connected to the connector 35 via the wiring formed on the base board 30 using a serial I/O interface. The communication circuit 31, the plurality of sensor circuits 32, and the plurality of motor circuits 33 are connected to the expansion module 20, via the wiring formed on the base board 30 using a parallel I/O interface. The core module 10 is connected to the base board 30, via the connector 15, the connection cable 13, and the connector 35, using a serial I/O interface.

The plurality of sensor circuits 32 are connected to the connector 34 via the wiring formed on the base board 30 using a parallel I/O interface. In the example shown in FIG. 3, the sensor circuits 32 are connected to two connectors 34a. The plurality of motor circuits 33 are connected to the connector 34 via the wiring formed on the base board 30 using a parallel I/O interface. In the example shown in FIG. 3, the motor circuits 33 are connected to two connectors 34b.

The mechatronic mechanism M includes a plurality of sensors 200 and a plurality of motors 201. The plurality of sensors 200 include a line sensor, a magnetic sensor, an image sensor, and the like, which acquire data for recognizing banknotes in the recognition unit 53 of the valuable media processing apparatus 40. The sensors 200 are connected to the connector 34 of the base board 30 via the connection cable 36 using a parallel I/O interface. In the example shown in FIG. 3, the sensors 200 are connected to the connector 34a.

The plurality of motors 201 include a motor that drives the transport mechanisms and a motor that drives the diverter mechanisms, of the transport paths of the handling-side transport unit 60 and the safe-side transport unit 90 in the valuable media processing apparatus 40. The motors 201 are connected to the connector 34 of the base board 30 via the connection cable 36. In the example shown in FIG. 3, the motors 201 are connected to the connector 34b.

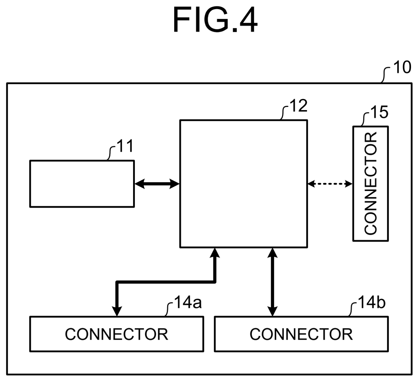

Next, another configuration example of the core module 10 will be described. FIG. 4 shows the other configuration example of the core module 10. The same parts as those in the core module 10 described with reference to FIG. 3 are denoted by the same reference characters and the detailed description thereof is omitted. The core module 10 shown in FIG. 4 includes the CPU 11, the FPGA 12, connectors 14a, 14b (hereinafter, sometimes collectively referred to as "connector 14"), and the connector 15.

The core module 10 shown in FIG. 4 incorporates the connector 14a and the connector 14b which can be connected directly to the sensor circuits 32 and the motor circuits 33 disposed on the base board 30. Thus, the sensor circuits 32 and the motor circuits 33 are connected to the connector 14, and the core module 10 can be used independently. The FPGA 12 is connected to the connectors 14a and 14b via wiring formed on the core module 10 using a parallel I/O interface. For connection to the expansion module 20, the FPGA 12 is connected to the connector 15 via the wiring formed on the core module 10 using a serial I/O interface.

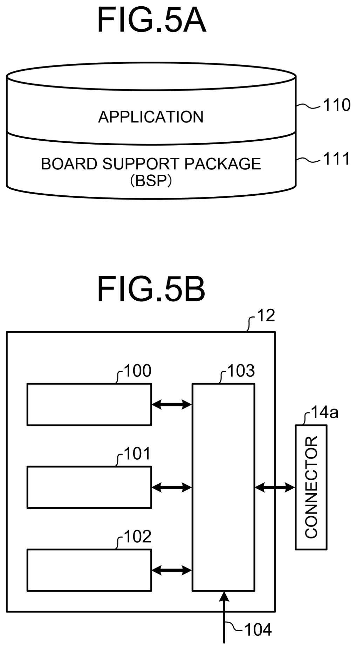

Next, a configuration example of programs implemented in the CPU 11 of the core module 10, and a configuration example of functional logics in each of the FPGA 12 of the core module 10 and the FPGA 21 of the expansion module 20 will be described. FIG. 5 shows the configuration example of the programs implemented in the core module 10, and the configuration example of functions implemented in the FPGA 12, 21.

As shown in FIG. 5A, a program for operating the CPU 11 of the core module 10 includes an application program 110 and a Board Suppot Pakage (BSP) program 111. The application program 110 is a program different for each product. For example, the application program includes a program related to a user interface or the like of the product. The Board Suppot Pakage program 111 is a program that is commonly used across different products. For example, the Board Suppot Pakage program 111 includes a program relating to a banknote recognition process which is commonly performed across multiple types of valuable media processing apparatuses 40, and a program relating to a process such as monitoring of the transport states of the handling-side transport unit 60 and the safe-side transport unit 90.

Functional logics that control the sensor circuits 32 and the motor circuits 33 mounted on the base board 30 are implemented in the FPGA 12 mounted on the core module 10 and the FPGA 21 mounted on the expansion module 20. Hereinafter, functional logics that control the motor circuits 33 will be described as an example.

For example, it is assumed that a motor 201 from one of three companies, company A, company B, or company C, is selected as the motor 201 to be used in the mechatronic mechanism M. In this case, as shown in FIG. 5B, a functional logic 100 that controls the motor 201 from company A, a functional logic 101 that controls the motor 201 from company B, and a functional logic 102 that controls the motor 201 from company C, are implemented in the FPGA 12 in advance.

The CPU 11 of the core module 10 determines which company's motor circuit 33, among companies A, B, and C, has been mounted on the base board 30. The CPU 11 transmits a selection signal based on the determination result to a selector 103 implemented in the FPGA 12 via a selection signal line 104. For example, in order to enable the CPU 11 to determine which company's motor circuit 33 has been mounted, an identification mechanism for identifying which company's motor 201 corresponds to the motor circuit 33 may be mounted on the base board 30.

Specifically, a 2-bit DIP (Dual In-line Package) switch is mounted on the base board 30, for example. It is assumed that the DIP-switch setting of "00" indicates a motor circuit from company A, the DIP-switch setting of "01" indicates a motor circuit from company B, and the DIP-switch setting of "10" indicates a motor circuit from company C. When the power is turned on, the CUP 11 reads the setting of the DIP switch, and transmits the selection signal to the selector 103 implemented in the FPGA 12 via the selection signal line 104. Here, although an example where the DIP switch is used is described, a circuit that transmits identification signals to the motor circuits 33 may be mounted in advance.

The FPGA 12 transmits the signal for a functional logic selected by the selector 103 to the connector 14a. For example, when the functional logic 100 is selected by the selector 103, the FPGA 12 transmits a control signal corresponding to the functional logic 100 to the connector 14a. Similar functions are also implemented in the FPGA 21 of the expansion module 20.

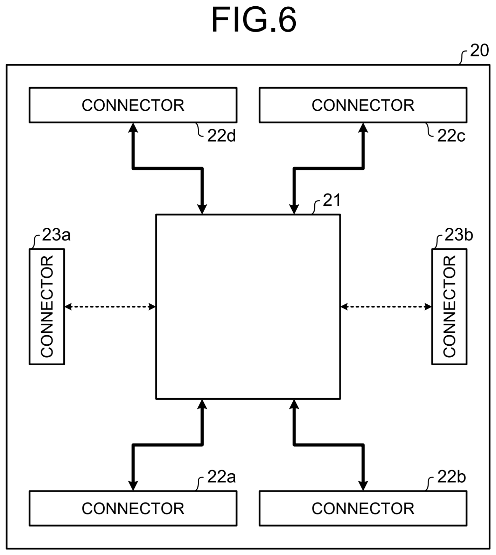

Next, a configuration example of the expansion module 20 will be described. FIG. 6 shows the configuration example of the expansion module 20. As shown in FIG. 6, the expansion module 20 includes the FPGA 21, connectors 22a, 22b, 22c, 22d (hereinafter, sometimes collectively referred to as "connector 22"), and connectors 23a, 23b. The FPGA 21 is connected to the connector 22 via the wiring formed on the printed circuit board using a parallel I/O interface.

The FPGA 21 is connected to the connector 23a for connection to the core module 10 via the wiring formed on the printed circuit board using a serial I/O interface. The FPGA 21 is connected to the connector 23b for connection to another expansion module 20 via the wiring formed on the printed circuit board using a serial I/O interface.

The program for operating the CPU 11 and the functional logics in the FPGA 12 and the FPGA 21, described above, can be modified from an external device, and access control relating to the modifications can also be executed. Specifically, the program for operating the CPU 11 of the core module 10 is access-controlled such that modifications can be made only from a first management device used by the manufacturing company of the valuable media processing apparatus 40, for example. Meanwhile, the functional logics of the FPGA 12 mounted on the core module 10 and the FPGA 21 mounted on the expansion module 20 may be access-controlled such that modifications can be made not only from the first management device used by the manufacturing company but also from a second management device used by a company other than the manufacturing company.

For example, the access control may be executed based on an IP address and/or a MAC address of each of the first management device and the second management device.

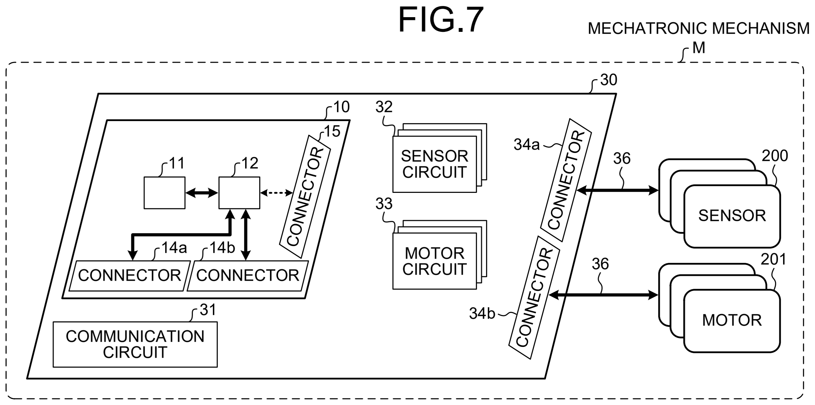

In the example shown in FIG. 3, both the core module 10 and the expansion module 20 are used. However, only the core module 10 may be used. Hereinafter, a mounting example in the valuable media processing apparatus 40 using only the core module 10 will be described. The same parts as those in the mounting configuration in the valuable media processing apparatus 40 shown in FIG. 3 are denoted by the same reference characters and the detailed description thereof is omitted. FIG. 7 shows a mounting configuration of the base board 30 using only the core module 10.

The mechatronic mechanism M of the valuable media processing apparatus 40 shown in FIG. 7 includes the base board 30 on which the core module 10 is mounted, the plurality of sensors 200, and the plurality of motors 201. The base board 30 includes no expansion module 20, and only the core module 10 is mounted on the base board 30.

The core module 10 is mounted on the base board 30 using the connector 14a, the connector 14b, and the connector 15. The FPGA 12, the communication circuit 31, the plurality of sensor circuits 32, and the plurality of motor circuits 33 are connected, via the connector 14a, the connector 14b, and the wiring formed on the base board 30, using a parallel I/O interface.

Signals from the sensors 200 are transmitted via the connection cable 36 and the connector 34a, the sensor circuits 32, the connector 14a or the connector 14b, and the FPGA 12, to the CPU 11 of the core module 10. The CPU 11 performs a recognition process on banknotes using the transmitted signals. The CPU 11 controls the motors 201 via the FPGA 12, the connector 14a or the connector 14b, the motor circuits 33, and the connector 34b and the connection cable 36.

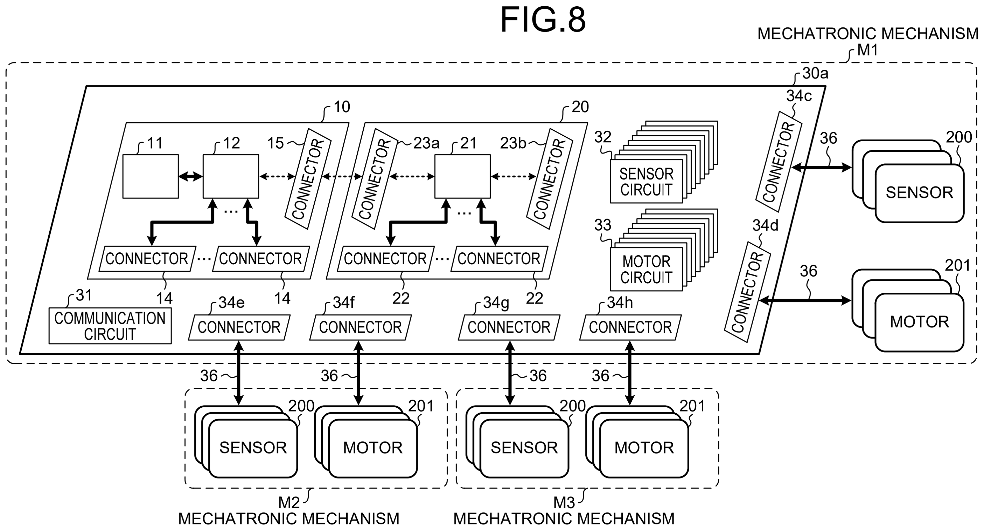

Next, an example in which a general-purpose control board is mounted in the valuable media processing apparatus 40 that controls more sensors 200 and more motors 201, will be described. The same parts as those in the mounting example in the valuable media processing apparatus 40 shown in FIG. 7 are denoted by the same reference characters and the detailed description thereof is omitted. FIG. 8 shows a mounting configuration of the core module 10 and the expansion module 20.

The valuable media processing apparatus 40 shown in FIG. 8 includes three mechatronic mechanisms M1 to M3. The first mechatronic mechanism M1 includes a base board 30a on which the core module 10 and the expansion module 20 are mounted, the plurality of sensors 200, and the plurality of motors 201. The second mechatronic mechanism M2 and the third mechatronic mechanism M3 each include the plurality of sensors 200 and the plurality of motors 201.

The base board 30a includes the core module 10, the expansion module 20, the communication circuit 31, the plurality of sensor circuits 32, the plurality of motor circuits 33, and connectors 34c, 34d, 34e, 34f, 34g, 34h. The core module 10 is connected to the expansion module 20, via the connector 15, the connector 23a, and wiring formed on the base board 30a, using a serial I/O interface.

The core module 10 is connected to some of the plurality of sensor circuits 32, via the connector 14 and the wiring formed on the base board 30a, using a parallel I/O interface. The core module 10 is connected to a part of the plurality of motor circuits 33, via the connector 14 and the wiring formed on the base board 30a, using a parallel I/O interface.

The expansion module 20 is connected to a part of the plurality of sensor circuits 32, via the connector 22 and the wiring formed on the base board 30a, using a parallel I/O interface. The expansion module 20 is connected to a part of the plurality of motor circuits 33, via the connector 22bb and the wiring formed on the base board 30a, using a parallel I/O interface.

The plurality of sensor circuits 32 are connected to the connector 34c, the connector 34e, or the connector 34g, according to the corresponding sensors 200, using a parallel I/O interface. The plurality of motor circuits 33 are connected to the connector 34d, the connector 34f, or the connector 34h, according to the corresponding motors 201, using a parallel I/O interface.

The base board 30a is connected to the plurality of sensors 200, via the connector 34c and the connection cable 36, using a parallel I/O interface. The base board 30a is connected to the plurality of motors 201, via the connector 34d and the connection cable 36, using a parallel I/O interface.

The base board 30a is connected to the plurality of sensors 200 of the second mechatronic mechanism M2, via the connector 34e and the connection cable 36, using a parallel I/O interface. The base board 30a is connected to the plurality of motors 201 of the second mechatronic mechanism M2, via the connector 34f and the connection cable 36, using a serial I/O interface.

The base board 30a is connected to the plurality of sensors 200 of the third mechatronic mechanism M3, via the connector 34g and the connection cable 36, using a parallel I/O interface. The base board 30a is connected to the plurality of motors 201 of the third mechatronic mechanism M3, via the connector 34h and the connection cable 36, using a parallel I/O interface.

In the example shown in FIG. 8, signals from the plurality of sensors 200 of the first mechatronic mechanism M1 are transmitted to the CPU 11 via the connection cable 36, the connector 34c, the sensor circuits 32, the connector 14, and the FPGA 12.

Signals from the plurality of sensors 200 of the second mechatronic mechanism M2 are transmitted to the CPU 11 via the connection cable 36, the connector 34e, the sensor circuits 32, the connector 14, and the FPGA 12. Signals from the plurality of sensors 200 of the third mechatronic mechanism M3 are transmitted to the CPU 11 via the connection cable 36, the connector 34g, the sensor circuits 32, the connector 22, the FPGA 21, the connector 23a, the connector 15, and the FPGA 12. Thus, the CPU 11 of the core module 10 can perform the recognition process on banknotes.

Control signals for the plurality of motors 201 of the first mechatronic mechanism M1 are transmitted from the CPU 11 to the motors 201 via the FPGA 12, the connector 14, the motor circuits 33, the connector 34d, and the connection cable 36. Control signals for the plurality of motors 201 of the second mechatronic mechanism M2 are transmitted from the CPU 11 to the motors 201 via the FPGA 12, the connector 14, the motor circuits 33, the connector 34f, and the connection cable 36. Control signals for the plurality of motors 201 of the third mechatronic mechanism M3 are transmitted from the CPU 11 to the motors 201 via the FPGA 12, the connector 15, the connector 23a, the FPGA 21, the connector 22, the motor circuits 33, the connector 34h, and the connection cable 36. Thus, the CPU 11 of the core module 10 can control each of the plurality of motors 201 of the first mechatronic mechanism M1, the second mechatronic mechanism M2, and the third mechatronic mechanism M3.

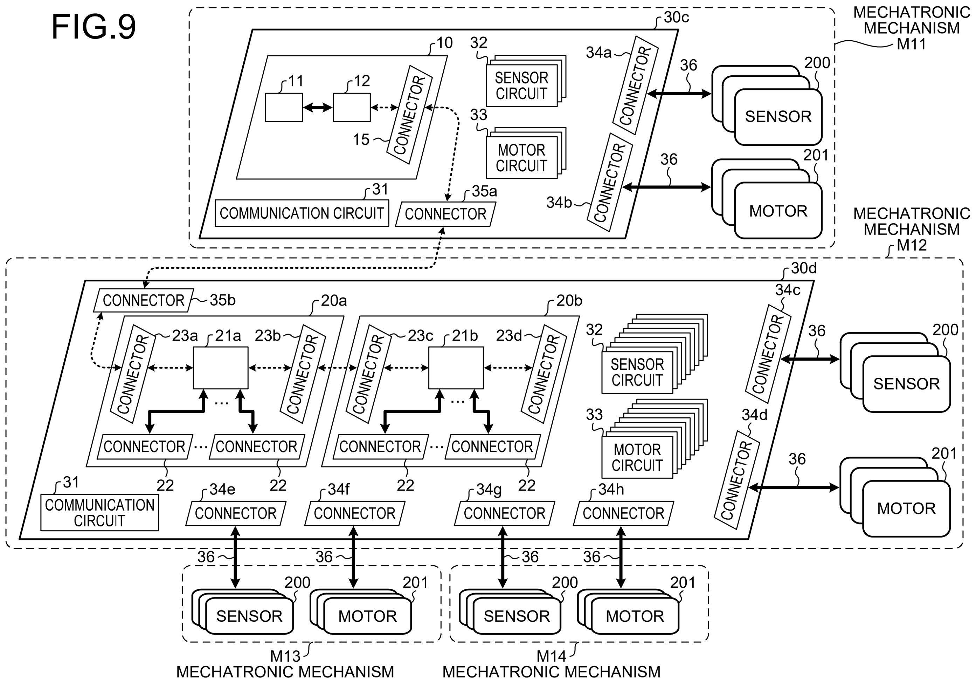

In the above example, one base board 30 is used. However, a plurality of the base boards 30 may be used in one base board 30. Hereinafter, an example in which two base boards 30, 30b and four mechatronic mechanisms M11 to M14 are mounted in the valuable media processing apparatus 40, will be described. The same parts as those in the mounting configuration in the valuable media processing apparatus 40 shown in each of FIG. 7 and FIG. 8 are denoted by the same reference characters and the detailed description thereof is omitted. FIG. 9 shows another mounting configuration of the core module 10 and the expansion module 20.

The valuable media processing apparatus 40 shown in FIG. 9 includes the four mechatronic mechanisms M11 to M14. The first mechatronic mechanism M11 includes the base board 30c on which the core module 10 is mounted, the plurality of sensors 200, and the plurality of motors 201. The second mechatronic mechanism M12 includes the base board 30d on which a first expansion module 20a and a second expansion module 20b are mounted, the plurality of sensors 200, and the plurality of motors 201. The third mechatronic mechanism M13 includes the plurality of sensors 200 and the plurality of motors 201. The fourth mechatronic mechanism M14 includes the plurality of sensors 200 and the plurality of motors 201.

In order to transmit control signals of the CPU 11 to another base board, the base board 30c of the first mechatronic mechanism M11 has a configuration in which a connector 35a is added to the base board 30 described with reference to FIG. 7. The core module 10 is connected to the connector 35a, via the connector 15 and wiring formed on the base board 30c, using a serial I/O interface. The base board 30c and the base board 30d are connected with each other, via the connector 35a mounted on the base board 30c and a connector 35b mounted on the base board 30d, using a serial I/O interface. Thus, the control signals transmitted from the CPU 11 and data acquired from the plurality of sensors 200 and transmitted to the CPU 11 can be mutually transmitted between the base board 30c and the base board 30d.

The base board 30d of the second mechatronic mechanism M12 includes the first expansion module 20a, the second expansion module 20b, the communication circuit 31, the plurality of sensor circuits 32, the plurality of motor circuits 33, the connectors 34c, 34d, 34e, 34f, 34g, 34h, and the connector 35b.

The first expansion module 20a is mounted on the base board 30d by using the plurality of connectors 22, the connector 23a, and the connector 23b. The first expansion module 20a is connected to the connector 35b, via the connector 23a and wiring formed on the base board 30d, using a serial I/O interface. The first expansion module 20a and the second expansion module 20 are connected with each other, via the connector 23b, the wiring formed on the base board 30d, and a connector 23c, using a serial I/O interface.

The first expansion module 20a is connected to a part of the plurality of sensor circuits 32, via the connector 22 and the wiring formed on the base board 30d, using a parallel I/O interface. The first expansion module 20a is connected to a part of the plurality of motor circuits 33, via the connector 22 and the wiring formed on the base board 30d, using a parallel I/O interface.

The second expansion module 20b is connected to a part of the plurality of sensor circuits 32, via the connector 22 and the wiring formed on the base board 30d, using a parallel I/O interface. The second expansion module 20b is connected to a part of the plurality of motor circuits 33, via the connector 22 and the wiring formed on the base board 30d, using a parallel I/O interface.

The plurality of sensor circuits 32 are connected to the connector 34c, the connector 34e, or the connector 34g, according to the corresponding sensors 200, using a parallel I/O interface. The plurality of motor circuits 33 are connected to the connector 34d, the connector 34f, or the connector 34h, according to the corresponding motors 201, using a parallel I/O interface.

The base board 30d is connected to the plurality of sensors 200, via the connector 34c and the connection cable 36, using a parallel I/O interface. The base board 30a is connected to the plurality of motors 201, via the connector 34d and the connection cable 36, using a parallel I/O interface.

The base board 30d is connected to the plurality of sensors 200 of the third mechatronic mechanism M13, via the connector 34e and the connection cable 36, using a parallel I/O interface. The base board 30d is connected to the plurality of motors 201 of the third mechatronic mechanism M13, via the connector 34f and the connection cable 36, using a parallel I/O interface.

The base board 30d is connected to the plurality of sensors 200 of the fourth mechatronic mechanism M14, via the connector 34g and the connection cable 36, using a parallel I/O interface. The base board 30d is connected to the plurality of motors 201 of the fourth mechatronic mechanism M14, via the connector 34h and the connection cable 36, using a parallel I/O interface.

In the example shown in FIG. 9, the connection between a plurality of the base boards connected to the sensors 200 is made using the serial I/O interface. Signals using the serial I/O interface are transmitted/received through the expansion module 20, whereby the data acquired from the plurality of sensors 200 connected to each base board can be transmitted to the CPU 11 of the core module 10. Thus, the CPU 11 of the core module 10 can perform the recognition process on banknotes.

The connection between the plurality of base boards connected to the motors 201 is made using the serial I/O interface. The signals using the serial I/O interface are transmitted/received through the expansion module 20, whereby the control signals from the CPU 11 of the core module 10 can be transmitted to the plurality of motors 201 connected to each base board. Thus, the CPU 11 of the core module 10 can control the plurality of motors 201 of the first mechatronic mechanism M11, the second mechatronic mechanism M12, the third mechatronic mechanism M13, and the fourth mechatronic mechanism M14.

In the example shown in FIG. 9, two base boards are connected with each other. However, base boards may each incorporate one or more expansion modules 20 and connectors and may be connected with each other using a serial I/O interface, thereby allowing three or more base boards to be connected with each other.

In order to avoid security risks, encrypted communication may be performed over the bus interface between the CPU 11 and the FPGA 12 of the core module 10 and the serial I/O interface between the core module 10 and the expansion module 20.

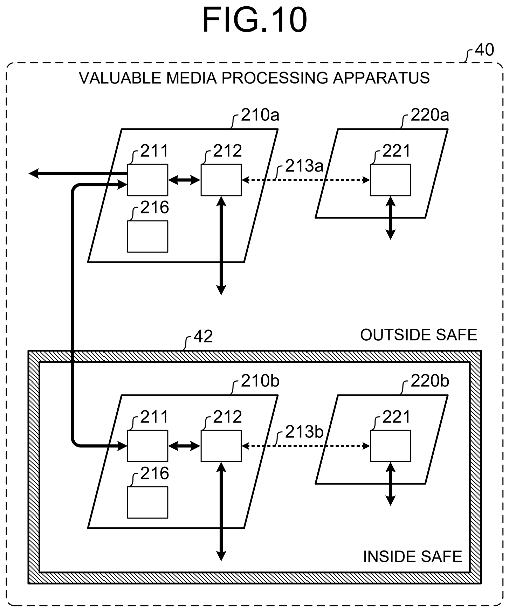

FIG. 10 illustrates an outline of a security-assured mounting configuration in the valuable media processing apparatus 40. FIG. 10 shows only a part of the valuable media processing apparatus 40. In FIG. 10, a base board is omitted, and only core modules 210a, 210b and expansion modules 220a, 220b are shown.

The core module 210a shown in FIG. 10 includes a CPU 211, an FPGA 212, and a TPM (Trusted Platform Module) 216. The CPU 211 controls the entirety of the valuable media processing apparatus 40 in which a base board is mounted. In the FPGA 212, functional logics that control the plurality of sensor circuits 32 and the plurality of motor circuits 33, which are used in the valuable media processing apparatus 40, are implemented. An encryption IP (Intellectual Property) core for encrypting a serial I/O interface is implemented in the FPGA 212. The type of encryption IP core is not particularly limited. For example, an IP core such as an AES (Advanced Encryption Standard) method or a SHA2 (Secure Hash Algorithm 2) method may be used. The TPM 216 generates and stores a secret key or the like which is used to encrypt communication with the second management device other than the manufacturing company.

In the core module 210a, data encrypted using the TPM 216 is transmitted/received through the system bus between the CPU 211 and the FPGA 212. Between the core module 210a and the expansion module 220a, data is transmitted/received in encrypted form using the encryption IP core implemented in the FPGA 212 and the FPGA 221. Similarly, between the core module 210b and the expansion module 220b, data is transmitted/received in encrypted form using the encryption IP core.

Data encrypted using a secret key generated based on the TMP 216 is transmitted/received even in the interface between the core module 210a mounted inside the handling unit 41 and the core module 210b mounted inside the safe unit 42 in the valuable media processing apparatus 40. The core module 210a may perform communication with external devices such as the second management device other than that of the manufacturing company of the valuable media processing apparatus 40. Even in such communication with external devices, data encrypted using the secret key generated based on the function of the TPM 216 is transmitted/received.

As described above, the TPM 216 is mounted on the core module 210a, a secret key or the like to be used for encryption is generated and stored by the TPM 216, and communication between the CPU 211 of the core module 210a and the CPU 211 of the core module 210b is encrypted using the secret key. Encryption IP cores are implemented in the FPGA 212 mounted on the core module 210a and the FPGA 221 mounted on the expansion module 220a, to encrypt communication between the FPGA 212 and the FPGA 221. Thus, security can be enhanced so as to prevent eavesdropping on communication between the modules and communication between the modules and external devices.

In the above-described example, a case where the sensor circuit 32 and the motor circuit 33 mounted on the base board 30 are replaced is described. However, in the present disclosure, even if an FPGA in use is replaced with an alternative FPGA, product manufacturing can continue.

For example, with reference to FIG. 1, it is assumed that an FPGA from one of three companies, company A, company B, or company C, is selected as the FPGA 21 to be mounted on the expansion module 20. A plurality of functional logics that control the sensor circuits 32 and the motor circuits 33 from multiple manufacturers, which are mounted on the base board 30 developed for each apparatus, are implemented in all the FPGAs 21 from company A, company B, and company C. The plurality of functional logics implemented in each FPGA can be designed as common programs by using RTL (Register Transfer Level) design, which enables common designs regardless of the manufacturer of the FPGA.

The CPU 11 of the core module 10 includes a program that operates all the FPGAs 21 from company A, company B, and company C, and is configured to determine which company's FPGA has been mounted, and to select and operate a corresponding program. Thus, even if it has become difficult to obtain the FPGA from company A, the FPGA from company B or company C is mounted on the expansion module 20, thereby enabling product manufacturing to continue.

Similarly, as the FPGA 12 mounted on the core module 10, an FPGA from any of multiple manufacturers anticipated in advance can be used. Thus, even if it has become difficult to obtain the FPGA from company A, the FPGA from company B or company C is mounted on the core module 10, thereby enabling product manufacturing to continue.

The components shown in the above embodiment are conceptually functional components, and thus may not necessarily be physically limited thereto. That is, distributed or integrated forms of each device are not limited to the forms illustrated in the drawings, and all or some of the forms may be distributed or integrated functionally or physically in any unit depending on various loads, use statuses, or the like.

## Claims

1. A general-purpose control board mountable on both a first specific board in a first apparatus and a second specific board in a second apparatus, the general-purpose control board comprising:
a processor configured to execute a first application that controls a user interface of an apparatus and realizes a function of the apparatus, to control the apparatus; and
a programmable device configured to incorporate a second application that operates a specific board in the apparatus, based on the first application executed by the processor.

2. The general-purpose control board according to claim 1, comprising:
a first board including the processor and the first programmable device; and
a second board including the second programmable device connected to the first programmable device.

3. The general-purpose control board according to claim 2, wherein the first board is connected to the second board using a serial I/O interface.

4. The general-purpose control board according to claim 3, wherein the first board and the second board communicate with each other by encrypting data.

5. The general-purpose control board according to claim 1, wherein
the first application is capable of being modified only from a first control device, and
the second application is capable of being modified from the first control device and a second control device.

6. The general-purpose control board according to any one of claims 1 to 4, wherein the apparatus is a valuable media processing apparatus configured to process a valuable medium.

7. The general-purpose control board according to claim 6, wherein
the valuable media processing apparatus includes a plurality of sensors and/or a plurality of motors that are used for processing a valuable medium, and
the plurality of sensors and/or the plurality of motors are electrically connected to the programmable device.

8. The general-purpose control board according to claim 6, wherein the plurality of sensors and/or the plurality of motors are electrically connected to the processor via the programmable device.

9. The general-purpose control board according to claim 6, wherein
the valuable media processing apparatus further includes a safe, and
the specific board on which the general-purpose control board is mounted is stored in the safe.
